# EUROPÄISCHE PATENTANMELDUNG

(11) **EP 1 584 920 A1**
(43) Veröffentlichungstag der Anmeldung: **12.10.2005**
(21) Anmeldenummer: 05004871.9
(22) Anmeldetag: 05.03.2005
(51) Int. Cl.: G01N 22/00, G01N 22/04, A24B 9/00, B65B 19/28, H01P 7/06, G01R 27/26

(54) **Temperaturstabiler Hohlraumresonator bestehend hauptsächlich aus nichtmetallischem Material wie z.B. Glas oder Glaskeramik**

(30) Priorität: 07.04.2004 DE 102004017597
(71) Anmelder: Hauni Maschinenbau AG, 21033 Hamburg (DE)
(72) Erfinder: Schröder, Dierk, 22399 Hamburg (DE)
(74) Vertreter: Grebner, Christian Georg Rudolf

(57) **Zusammenfassung**

Die Erfindung betrifft ein Resonatorgehäuse (4) zur Erfassung wenigstens einer Eigenschaft, beispielsweise der Masse oder der Feuchte, eines Stranges (1) der Tabak verarbeitenden Industrie.

Die Erfindung besteht darin, dass der die Formgebung des Resonators wesentlich bestimmende Teil des Gehäuses (4) wenigstens teilweise aus nichtmetallischem Material mit einem sehr niedrigen Temperaturausdehnungskoeffizienten besteht. In einem Ausführungsbeispiel bestehen sowohl Hohlzylinder (6) als auch Deckel (8) beispielsweise aus Glas oder einer Glaskeramik. Der Resonatorraum ist mit einer dünnen Goldschickt (12) bedampft.

## Beschreibung

Die Erfindung betrifft ein Resonatorgehäuse zur Erfassung wenigstens einer Eigenschaft eines Stranges der Tabak verarbeitenden Industrie. Schließlich betrifft die Erfindung die Verwendung eines Materials für einen Teil eines Resonatorgehäuses.

Unter einem Strang der Tabak verarbeitenden Industrie wird ein umhüllter oder unumhüllter Strang aus rauchfähigem Material wie Schnitttabak, Zigarillotabak, Zigarrentabak oder einem anderen rauchfähigen Material verstanden; unter diesem Ausdruck kann auch ein Strang aus einem Filtermaterial wie Zelluloseacetat oder Papier verstanden werden.

Es ist, z.B. durch die EP 0 791 823 A2, bekannt, zum Erfassen der Masse und/oder der Feuchtigkeit eines Tabakstranges, insbesondere eines aus mit Zigarettenpapier umhüllten Schnitttabak bestehenden Zigarettenstranges, den Strang durch eine Messkammer (im Folgenden "Resonatorgehäuse") genannt, aus metallischem Material zu führen, in der er von Mikrowellen beaufschlagt wird. Aus Veränderungen charakteristischer Werte der zugeführten Mikrowellen bei durch einen Strang durchsetztem Resonatorgehäuse und bei z.B. leerem Resonatorgehäuse oder relativ zu Standardwerten kann durch besondere Auswertschaltungen auf z.B. die Masse und/oder Feuchte je Längeneinheit des Stranges geschlossen werden.

Aus der DE 198 54 550 A1 ist bekannt, dass ein Resonatorgehäuse aus metallischem Material wenigstens teilweise aus Material mit einem niedrigen thermischen Ausdehnungskoeffizienten besteht. Der thermische Ausdehnungskoeffizient α gibt an, um welchen Anteil der Gesamtlänge ein Material sich ausdehnt, wenn es um ein Kelvin (K) erwärmt wird.

Als bevorzugte Ausführung ist eine Legierung, die ca. 64% Eisen und ca. 36% Nickel enthält, angegeben. Diese Legierung, auch "INVAR" genannt, besitzt bei Raumtemperatur einen thermischen Ausdehnungskoeffizienten α von etwa 10⁻⁶ K⁻¹. Das bedeutet, dass ein Stück des Materials, welches in eine Richtung eine Länge von einem Meter hat, sich bei der Erhöhung der Temperatur um ein Kelvin um einen Mikrometer (10⁻⁶ m) ausdehnt. Typische thermische Ausdehnungskoeffizienten von Metallen wie z.B. Eisen sind um einen Faktor zehn größer als der von INVAR.

Um eine weitere Erhöhung der Stabilität der Dimensionierung des Resonatorraums zu erreichen, ist in der DE 198 54 550 A1 weiterhin ausgeführt, dass das Resonatorgehäuse eine Temperaturregelanordnung aufweist, die seine Arbeitstemperatur zumindest annähernd konstant hält.

Die der Erfindung zugrunde liegende Aufgabe besteht in der Angabe eines Resonatorgehäuses mit hoher Messgenauigkeit und/oder Messempfindlichkeit.

Die erfindungsgemäße Lösung dieser Aufgabe besteht darin, dass der die Formgebung des Resonators wesentlich bestimmende Teil des Gehäuses wenigstens teilweise aus nichtmetallischem Material besteht.

Der die Formgebung des Resonators wesentlich bestimmende Teil des Gehäuses besteht aus den Komponenten, die flächig die Resonatorwand stützen oder bilden. Antennen, durch die die Mikrowellen in den Resonator ein- und ausgekoppelt werden, und gegebenenfalls vorhandene Isolierringe um die Antennen, durch welche die Antennen vom Gehäuse und von der Resonatorwand isoliert werden, gehören nicht zum Gehäuse im Sinne der Erfindung.

Unter nichtmetallischen Materialien werden in Abgrenzung zu metallischen Materialien insbesondere nichtmetallische Werkstoffe verstanden, also z.B. Keramiken, Kunststoffe, Gläser und Glaskeramiken. Diese Werkstoffe werden auch bei Anwesenheit von Metallatomen, z.B. durch Dotierung oder Beimengung, nicht als metallische Materialien bezeichnet, da die Anwesenheit der Metallatome ihnen nicht sämtliche metallischen Eigenschaften verleiht. Eine Dotierung der Werkstoffe, auch mit nichtmetallischen Atomen, Ionen oder Molekülen, kann allerdings auch zu einem nichtmetallischen Material führen, das elektrisch leitend ist.

Es ist im Sinne der Erfindung zu unterscheiden zwischen einem Resonatorgehäuse und einem Resonator. Ein Resonator ist ein Hohlraum (Resonatorraum), welcher wenigstens teilweise durch elektrisch leitfähiges Material eingegrenzt ist (Resonatorwand). In den Resonatorraum eingeführte elektromagnetische Wellen werden an der elektrisch leitenden Resonatorwand reflektiert und können sich, entsprechend den von der Frequenz der elektromagnetischen Wellen abhängigen Resonanzeigenschaften des Resonators konstruktiv (verstärkend) oder destruktiv (abschwächend) überlagern. Die Frequenzabhängigkeit der Resonanz führt zu einer charakteristischen Resonanzkurve, deren Verlauf von der Formgebung des Resonatorraums abhängt, von den für die Resonatorwände verwendeten Materialien und von weiterem Material im Resonatorraum.

Je schlechter die elektrische Leitfähigkeit des Wandmaterials ist, umso schlechter werden die elektromagnetischen Wellen reflektiert, und umso schwächer kann sich eine Resonanz ausbilden. Bei Anwesenheit von Material im Resonatorraum wird ein Teil der elektromagnetischen Wellen absorbiert, so dass die Resonanz ebenfalls geschwächt wird oder sich die Resonanzfrequenz verschiebt. Weiterhin wird eine Änderung der Form des Resonators darin resultieren, dass der Frequenzverlauf der Resonanzkurve sich ändert.

Das Resonatorgehäuse hingegen umgibt den Resonator bzw. den Resonatorraum und gibt ihm seine Form. Wenn das Resonatorgehäuse selbst aus einem elektrisch leitfähigen Material besteht, so kann die den Resonator einschließende Innenwandung des Gehäuses als zum Resonator gehörige Resonatorwand betrachtet werden, wie nachstehend näher erläutert wird.

Aufgrund des bei hohen Frequenzen von elektromagnetischen Wellen auftretenden Skin-Effekts dringen Mikrowellen nur wenige Mikrometer tief in die Resonatorwand ein. Bei dem Material außerhalb dieser wenige Mikrometer dünnen Schicht ist es für die Ausbildung einer Resonanz im Resonator unerheblich, ob das Material elektrisch leitfähig ist.

Abhängig von den Eigenschaften des Materials oder der Materialien, aus denen das Resonatorgehäuse besteht, kann es sinnvoll oder notwendig sein, die den Resonator umschließende Innenfläche des Resonatorgehäuses mit einem elektrisch gut leitfähigen und insbesondere korrosionsbeständigen Material zu beschichten. In diesem Falle ist nur die Beschichtung als Resonatorwand zu betrachten. Das Resonatorgehäuse dient in diesem Falle nur als ein Stützgehäuse für einen nichtselbsttragenden Resonator.

Da die Resonanz der in den Resonator eingeführten Mikrowellen empfindlich von der Form und von der Dimensionierung des Resonatorraums abhängt, ist es wichtig, die Form und die Dimensionierung des Resonators unabhängig von Umgebungseinflüssen, wie z.B. der Temperatur, konstant zu halten.

Vorteilhaft bestehen diejenigen Teile des Resonatorgehäuses, die die Form des Resonatorraums bestimmen, aus dem nichtmetallischen Material mit niedrigem Ausdehnungskoeffizienten. Somit sind auch die Dimensionierung und die Form des Resonatorraums weitgehend unabhängig von der Umgebungstemperatur. Dadurch ist eine weitgehend konstante Amplitude und Form der charakteristischen Resonanzkurve des Resonatorraums für Mikrowellen gewährleistet und das Erfordernis eines konstanten Bezugsmaßes für die Messung erfüllt. Vorzugsweise ist der thermische Ausdehnungskoeffizient des nichtmetallischen Materials in wenigstens einem Temperaturbereich von 20°C bis 40°C kleiner als 10⁻⁶ K⁻¹.

Geeignete nichtmetallische Materialien mit niedrigen thermischen Ausdehnungskoeffizienten sind bekannt. Beispielhaft zu nennen sind einige spezielle Glaskeramiken und Gläser, deren Herstellungsprozesse speziell auf die Erreichung eines niedrigen thermischen Ausdehnungskoeffizienten hin optimiert sind.

Die Glaskeramik Zerodur® der Firma Schott Glas, Mainz, besitzt im Temperaturbereich 0°C bis 50°C einen mittleren thermischen Längenausdehnungskoeffizienten von 0 ± 0,1 ·10⁻⁶ K⁻¹ oder besser, was bedeutet, dass eine thermische (quasi-)Nullausdehnung mit einer Fertigungstoleranz von 0, 1 ·10⁻⁶ K⁻¹ erreicht wird. Der Grundstoff für diese Glaskeramik ist ein Glasblock, welcher in einem Keramisierprozess erhitzt und kontrolliert wieder abgekühlt wird. Bei der kontrollierten Abkühlung wird neben der glastypischen amorphen Glasphase eine kristalline Phase herangezüchtet, die 70 bis 78 Gewichtsprozent des Materials ausmacht. Die thermischen Ausdehnungskoeffizienten der zwei Phasen sind einander entgegengesetzt. Das heißt, dass sich bei Erwärmung des Materials die eine Phase ausdehnt, während die andere kontrahiert. Die Gewichtsanteile der beiden Phasen in dem Material sind so gewählt, dass die entgegengesetzten thermischen Ausdehnungskoeffizienten der kristallinen Phase und der amorphen Glasphase sich in der Summe aufheben, so dass eine thermische (quasi-)Nullausdehnung resultiert. Die mechanischen Eigenschaften und die Bearbeitbarkeit des Materials entsprechen denen von Glas.

Das Material ULE® von der Firma Corning Inc., New York, ist ein Glas, das einen mittleren thermischen Ausdehnungskoeffizienten von 0 ± 0,03 ·10⁻⁶ K⁻¹ besitzt. Dieses Material wird in einem Flammenhydrolyseverfahren auf einem Sandsubstrat abgeschieden. Dabei wird im Wesentlichen Quarzglas verdampft, und der Flamme werden Titan-Ionen beigefügt. Das abgeschiedene Substrat ist im Wesentlichen ein mit Titan-Ionen dotiertes Glas. In diesem Falle ist die Beimischung von Titan-Ionen für die Nullausdehnung verantwortlich.

Die angeführten Materialien sind ohne Einschränkung der erfindungsgemäßen Materialen stellvertretend für nichtmetallische Materialien mit niedrigem thermischem Ausdehnungskoeffizienten genannt.

Die Messung des thermischen Ausdehnungskoeffizienten eines Materials mit sehr niedrigem Wert für α geschieht zweckmäßig durch Interferometrie an Maßverkörperungen, z.B. Kugelinterferometrie, Planflächeninterferometrie oder Präzisionsinterferometrie. Diese z.B. bei der Physikalisch-Technischen Bundesanstalt, Braunschweig, Deutschland, angewandten Messmethoden eignen sich sowohl für metallische als auch für nichtmetallische Materialien.

In einer vorteilhaften Ausgestaltung ist vorgesehen, dass der die Formgebung des Resonators wesentlich bestimmende Teil des Gehäuses wenigstens teilweise aus einer Glaskeramik besteht. Ebenso ist es vorteilhaft, dass der die Formgebung des Resonators wesentlich bestimmende Teil des Gehäuses wenigstens teilweise aus einem Glas besteht. Hierbei werden unter einer Glaskeramik oder einem Glas Materialien wie oben beschrieben verstanden, welche einen besonders niedrigen thermischen Ausdehnungskoeffizienten aufweisen. Durch die Verwendung eines Materials mit einem derart niedrigen thermischen Ausdehnungskoeffizienten entfällt die Notwendigkeit, eine Temperaturregeleinrichtung vorzusehen. Bei Betriebstemperaturen von Raumtemperatur bis ca. 40°C ist eine den Erfordernissen der Messgenauigkeit entsprechende Konstanz der Resonatorgeometrie gewährleistet. Die Notwendigkeit einer Temperaturregelungseinrichtung entfällt vorzugsweise.

In der Ausgestaltung des Resonatorgehäuses ist in einer Weiterbildung vorgesehen, dass der Resonatorraum die Form eines symmetrischen Hohlkörpers aufweist. Zur Erzeugung eines möglichst homogenen Mikrowellenresonanzfeldes ist es dabei vorteilhaft, dass der Resonatorraum wenigstens abschnittsweise die Form eines rotationssymmetrischen Hohlkörpers, vorzugsweise eines Hohlzylinders, aufweist. Insbesondere bei einer Ausrichtung der Symmetrieachse des Hohlkörpers entlang der Förderrichtung des Messobjekts ist so eine Resonanzmode erreichbar, welche eine besonders große Feldstärke am Ort des Messobjektes aufweist.

Die Form des Resonatorraums kann von der exakten Form eines Hohlzylinders abweichen. Vorteilhaft ist aber auch dann eine zumindest annähernd symmetrische Form, z.B. eine Polygon-Form.

Eine vorteilhafte Ausführung des Resonatorgehäuses besteht darin, dass ein Verschlusselement zum Verschließen des Innenraums des Resonatorgehäuses umfasst ist. Das Verschlusselement ist vorteilhaft betriebsmäßig entfernbar und wiederanbringbar, so dass der Innenraum des Resonatorgehäuses gewartet und gesäubert werden kann.

Eine vorteilhafte Ausführung des Resonatorgehäuses besteht darin, dass die den Resonator eingrenzenden Oberflächen des Resonatorgehäuses wenigstens teilweise mit einem korrosionsbeständigen Material hoher elektrischer Leitfähigkeit beschichtet sind. Dieses kann bei einigen nichtmetallischen Materialen als Bestandteil des Resonatorgehäuses sinnvoll sein, da bei hochfrequenten elektromagnetischen Wechselfeldern, wie z.B. Mikrowellen, die auf die Grenzfläche eines Materials treffen, die Reflektion der elektromagnetischen Wellen durch das Auftreten des Skin-Effekts gedämpft wird.

Zur Kompensation dieses Effekts wird die Oberfläche des Innenraums des Resonators mit einem Material hoher elektrischer Leitfähigkeit beschichtet. Im Rahmen der Erfindung wird unter hoher elektrischer Leitfähigkeit ein Wert von etwa 10 ·10⁶ S/m oder mehr verstanden. Materialien mit hoher elektrischer Leitfähigkeit sind beispielsweise Gold (42 ·10⁶ S/m), Kupfer (60 ·10⁶ S/m) und Silber (63·10⁶ S/m).

Im Interesse einer langfristigen Stabilität der Messergebnisse, insbesondere bedingt durch die Stabilität der Form und Dimensionierung des Resonatorraums, ist es von Vorteil, dass sich die elektrische Leitfähigkeit des Beschichtungsmaterials im Laufe der Zeit nicht verändert. Dafür ist es vorgesehen, dass das Material korrosionsbeständig ist.

In einer besonders vorteilhaften Ausgestaltung ist es vorgesehen, dass das zur Beschichtung verwendete Material im Wesentlichen aus Gold besteht oder wenigstens Gold enthält. Ebenfalls bekannt sind leitfähige Kunststoffe, welche ebenfalls über eine hohe Korrosionsbeständigkeit verfügen. Auch diese Kunststoffe kommen für eine Beschichtung in Frage.

Es sind auch nichtmetallische Materialien bekannt, welche elektrisch leitfähig sind oder z. B. durch Dotierung elektrisch leitfähig werden. Es ist daher vorzugsweise vorgesehen, dass das nichtmetallische Material elektrisch leitend ist.

Um mechanische Spannungen gering zu halten, welche durch die Verwendung von Materialien mit verschiedenen thermischen Ausdehnungskoeffizienten herrühren, besteht eine vorteilhafte Ausbildung des Resonatorgehäuses darin, dass es im Wesentlichen vollständig aus dem nichtmetallischen Material besteht. Hierdurch wird erreicht, dass eine thermische Ausdehnung oder Kontraktion eines anderen Bauteils des Resonatorgehäuses keine Auswirkung auf die Formgebung des Resonators hat.

Die der Erfindung zugrunde liegende Aufgabe wird weiterhin durch ein Messgerät mit einem Resonatorgehäuse, wobei das Resonatorgehäuse wie oben beschrieben ausgeführt ist, gelöst.

Die der Erfindung zugrunde liegende Aufgabe wird gelöst durch die Verwendung eines nichtmetallischen Materials mit einem thermischen Ausdehnungskoeffizienten, der wenigstens in einem Temperaturbereich von 20°C bis 40°C kleiner ist als 10⁻⁶ K⁻¹, für wenigstens einen Teil des die Formgebung des Resonators wesentlich bestimmenden Teils eines Resonatorgehäuses zur temperaturregelfreien Erfassung wenigstens einer Eigenschaft eines Stranges der Tabak verarbeitenden Industrie. Ein Resonatorgehäuse aus dem beschriebenen Material stellt in dem angegebenen Temperaturbereich eine Form- und Größenstabilität des Resonatorraums sicher, wodurch eine hohe Reproduzierbarkeit der Messergebnisse gewährleistet ist.

In weiterer vorteilhafter Ausgestaltung der Erfindung ist ein den Strang umgebendes Schutzrohr vorgesehen. Das Schutzrohr besteht vorteilhaft zumindest teilweise aus einem Kunststoff, insbesondere der Polyaryletherketon-Gruppe (PEAK-Gruppe), insbesondere aus Polyetheretherketon (PEEK). Das Schutzrohr gemäß der Erfindung kann im Einlaufbereich des Stranges erweitert sein.

Das Resonatorgehäuse kann sich gemäß der Erfindung außerhalb des Innenraumes (Resonatorraum) nach außen in Richtung des Stranges zwecks Verhinderung des Austritt von Mikrowellen fortsetzen. Das Resonatorgehäuse kann sich auch innerhalb des Resonatorraums nach innen in Richtung des Strangs fortsetzen. Die Erfindung weist zahlreiche Vorteile auf:
Das Resonatorgehäuse und der Resonatorraum aus nichtmetallischem Material mit extrem bzw. sehr geringem Temperaturausdehnungskoeffizienten verändert seine Form bei wechselnden Temperaturen sehr wenig. Die Folge ist eine sehr gute Konstanz der Resonatoreigenschaften, was der Genauigkeit und Konstanz der Messwerterfassung zugute kommt.
Die Verwendung von korrosionsbeständigem Material, wie z.B. Gold, für die Beschichtung des Resonatorraums verhindert Korrosion und dadurch ausgelöste Änderungen der Resonatoreigenschaften. In Folge der guten elektrischen Leitfähigkeit dieses Beschichtungsmaterials werden negative Einflüsse durch den so genannten Skin-Effekt weitgehend hintangehalten.
Das Resonatorgehäuse ist für die Mikrowellenzufuhr und die Umwandlung der Mikrowellensignale in Messsignale gemäß der Erfindung besonders geeignet.

Die Erfindung wird nachstehend ohne Beschränkung des allgemeinen Erfindungsgedankens anhand eines Ausführungsbeispiels unter Bezugnahme auf die Zeichnung beschrieben, auf die im Übrigen bezüglich der Offenbarung aller im Text nicht näher erläuterten erfindungsgemäßen Einzelheiten ausdrücklich verwiesen wird. Es zeigt:

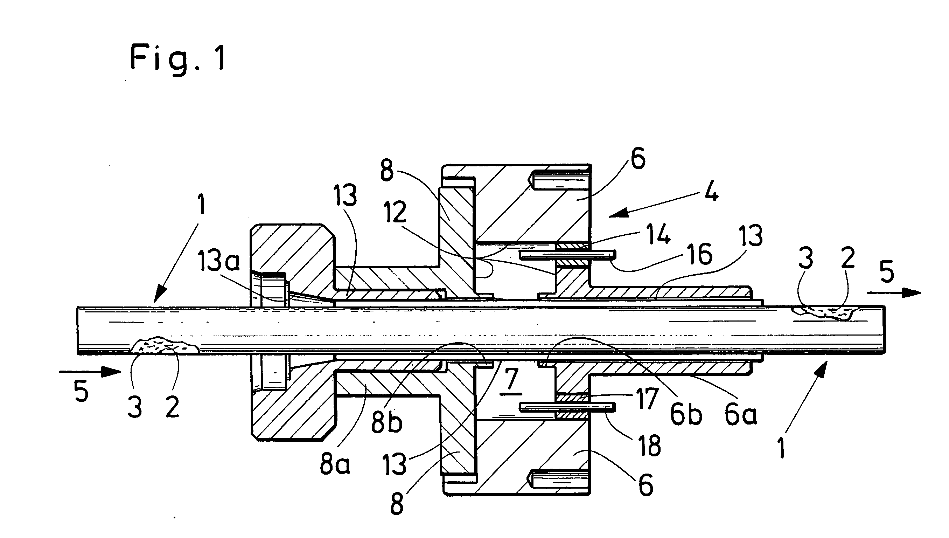

- Fig. 1: eine schematische Darstellung eines Resonatorgehäuses

Fig. 1 zeigt einen teilweise aufgebrochenen, in Richtung des Pfeils 5 bewegten Zigarettenstrang 1, bestehend aus einem Füller 2 aus Schnitttabak und einer Umhüllung 3 aus Zigarettenpapier, der ein Resonatorgehäuse 4 durchsetzt, dem Mikrowellen zwecks Erfassung wenigstens einer Eigenschaft des Füllers 2, beispielsweise der Masse oder der Feuchte, zugeführt werden. Das Resonatorgehäuse 4 weist einen Hohlkörper in Form eines Hohlzylinders 6 auf, dessen Innenraum (Resonatorraum) 7 symmetrisch zu dem Zigarettenstrang 1 angeordnet ist. An ihm ist ein Deckel 8 zum Verschließen angeschraubt. Sowohl Hohlzylinder 6 als auch Deckel 8 bestehen aus nichtmetallischem Material mit einem sehr niedrigen Temperaturausdehnungskoeffizienten, beispielsweise einem Glas oder einer Glaskeramik. Wenigstens der Hohlzylinder 6 sollte aus dem nichtmetallischen Material mit dem sehr niedrigen Temperaturausdehnungskoeffizienten bestehen. In Folge der guten Konstanz der Geometrie des Resonatorgehäuses 4 und des Resonatorraums 7 lässt sich auch eine gute Konstanz der Messergebnisse erreichen.

Der Resonatorraum 7 des Resonatorgehäuses 4 ist mit einer dünnen Goldschicht 12 bedampft, die eine die Messwertkonstanz beeinträchtigende Korrosionsbildung zuverlässig verhindert und gleichzeitig, da elektrisch gut leitend, einen schädlichen Skin-Effekt begrenzt.

Zum mechanischen Abschluss des Resonatorraums 7 gegenüber dem Zigarettenstrang 1 und von diesem eventuell angeförderten Schmutzteilchen, also zwecks Verhinderung einer Verschmutzung des Resonatorraums 7, die das Messergebnis beeinträchtigen würde, dient ein Schutzrohr 13, das vorteilhaft aus einer Substanz der Polyaryletherketon (PAEK)-Gruppe, z. B. aus Polyetheretherketon (PEEK) besteht. An einem seiner Enden 13a, an dem der Strang 1 in das Resonatorgehäuse 6 einläuft, ist das Schutzrohr 13 trichterförmig aufgeweitet.

Das Resonatorgehäuse 4 erstreckt sich außerhalb des Resonatorraums 7 rohrförmig (6a, 8a) auf beiden Seiten in Richtung des Strangs 1 nach außen, um den Austritt von Mikrowellen aus der Resonatorkammer zu verhindern. Es erstreckt sich auch rohrförmig (6b, 8b) etwas nach innen. Zur Einkopplung der von einem Mikrowellengenerator erzeugten Mikrowellen dient eine durch einen Isolierring 14 vom Hohlzylinder 6 isolierte Antenne 16. Zum Auskoppeln von Mikrowellen, die einer nicht dargestellten Auswertschaltung zugeführt werden sollen, dient eine durch eine Isolierung 17 vom Hohlzylinder 6 isolierte Antenne 18. Eine geeignete Auswertschaltung ist der deutschen Patentanmeldung DE 197 34 978.1 zu entnehmen.

Auf die Isolierungen 14 und 17 kann verzichtet werden, falls der Hohlzylinder 6 selbst nicht leitend ist. Bei einem leitfähigen nichtmetallischen Material des Hohlzylinders 6 sind die lsolierringe bzw. Isolierungen 14 und 17 für die Koppelantennen 16 und 18 notwendig.

### Bezugszeichenliste

- 1: Zigarettenstrang
- 2: Füller
- 3: Umhüllung
- 4: Resonatorgehäuse
- 5: Bewegungsrichtung
- 6: Hohlzylinder
- 6a: äußere Erstreckung Hohlzylinder
- 6b: innere Erstreckung Hohlzylinder
- 7: Resonatorraum
- 8: Decke
- 8a: äußere Erstreckung Decke
- 8b: innere Erstreckung Decke
- 12: Goldschicht
- 13: Schutzrohe
- 13a: Schutzrohreinlass
- 14: Isolierring
- 16: Einkopplungsantenne
- 17: Isolierung
- 18: Auskopplungsantenne

## Patentansprüche

1. Resonatorgehäuse (4) zur Erfassung wenigstens einer Eigenschaft eines Stranges (1) der Tabak verarbeitenden Industrie, **dadurch gekennzeichnet, dass** der die Formgebung des Resonators wesentlich bestimmende Teil des Gehäuses (4) wenigstens teilweise aus nichtmetallischem Material besteht.

2. Resonatorgehäuse (4) nach Anspruch 1, **dadurch gekennzeichnet, dass** der die Formgebung des Resonators wesentlich bestimmende Teil des Gehäuses (4) einen thermischen Ausdehnungskoeffizienten aufweist, der wenigstens in einem Temperaturbereich von 20°C bis 40°C kleiner ist als 10⁻⁶ K⁻¹.

3. Resonatorgehäuse (4) nach Anspruch 1 oder 2, **dadurch gekennzeichnet, dass** der die Formgebung des Resonators wesentlich bestimmende Teil des Gehäuses (4) wenigstens teilweise aus einer Glaskeramik besteht.

4. Resonatorgehäuse (4) nach einem oder mehreren der Ansprüche 1 bis 3, **dadurch gekennzeichnet, dass** der die Formgebung des Resonators wesentlich bestimmende Teil des Gehäuses (4) wenigstens teilweise aus einem Glas besteht.

5. Resonatorgehäuse (4) nach einem oder mehreren der Ansprüche 1 bis 4, **dadurch gekennzeichnet, dass** der Resonatorraum (7) des Gehäuses (4) wenigstens abschnittsweise die Form eines symmetrischen Hohlkörpers aufweist.

6. Resonatorgehäuse (4) nach einem oder mehreren der Ansprüche 1 bis 5, **dadurch gekennzeichnet, dass** die den Resonator eingrenzenden Oberflächen des Resonatorgehäuses (7) wenigstens teilweise mit einem korrosionsbeständigen Material hoher elektrischer Leitfähigkeit beschichtet sind.

7. Resonatorgehäuse (4) nach Anspruch 6, **dadurch gekennzeichnet, dass** das zur Beschichtung verwendete Material im Wesentlichen aus Gold besteht oder wenigstens Gold enthält.

8. Resonatorgehäuse (4) nach einem oder mehreren der Ansprüche 1 bis 7, **dadurch gekennzeichnet, dass** das nichtmetallische Material elektrisch leitend ist.

9. Resonatorgehäuse (4) nach einem oder mehreren der Ansprüche 1 bis 8, **dadurch gekennzeichnet, dass** es im Wesentlichen vollständig aus dem nichtmetallischen Material besteht.

10. Messgerät mit einem Resonatorgehäuse (4) nach einem oder mehreren der Ansprüche 1 bis 9.

11. Verwendung eines nichtmetallischen Materials mit einem thermischen Ausdehnungskoeffizienten, der wenigstens in einem Temperaturbereich von 20°C bis 40°C kleiner ist als 10⁻⁶ K⁻¹, für wenigstens einen Teil des die Formgebung des Resonators wesentlich bestimmenden Teils eines Resonatorgehäuses (4) zur temperaturregelfreien Erfassung wenigstens einer Eigenschaft eines Stranges (1) der Tabak verarbeitenden Industrie.
